# FASCICULE DE BREVET EUROPEEN

(11) **EP 3 728 108 B1**
(45) Date de publication et mention de la délivrance du brevet: **12.04.2023**
(21) Numéro de dépôt: 18842788.4
(22) Date de dépôt: 20.12.2018
(51) Int. Cl.: B81B 7/00

(54) **MISE EN OEUVRE D'UNE STRUCTURE DE DÉCOUPLAGE POUR L'ASSEMBLAGE D'UN COMPOSANT AVEC UN BOITIER**
VERWENDUNG EINER ENTKOPPLUNGSSTRUKTUR ZUR MONTAGE EINES BAUTEILS MIT EINEM GEHÄUSE
USE OF AN UNCOUPLING STRUCTURE FOR ASSEMBLING A COMPONENT HAVING A CASING

(30) Priorité: 22.12.2017 FR 1763159
(43) Date de publication de la demande: 28.10.2020
(73) Titulaire: COMMISSARIAT À L'ÉNERGIE ATOMIQUE ET AUX ÉNERGIES ALTERNATIVES, 75015 Paris (FR)
(72) Inventeur: ROBERT, Philippe, 38000 GRENOBLE (FR)
(74) Mandataire: Brevalex
(86) Numéro de dépôt international: PCT/FR2018/053435
(87) Numéro de publication internationale: WO 2019/122733

(56) Documents cités:
- WO-A1-2009/060029
- DE-A1-102013 211 555
- US-A1- 2010 300 201

## Description

### DOMAINE TECHNIQUE ET ART ANTÉRIEUR

La présente demande se rapporte au domaine des systèmes formés d'un assemblage de composant(s), en particulier électro-mécanique(s) MEMS (pour "microelectromechanical systems" selon la terminologie anglo-saxonne) et/ou NEMS (pour "nano-electromechanical systems") sur un support, en particulier un boîtier de circuit. Le boîtier est généralement un PCB (pour « Printed Circuit Board » ou circuit imprimé en français) mais peut être également un boîtier céramique, un boîtier métallique ou tout autre type de boîtier ou d'assemblage et sert d'interface entre le composant électromécanique et d'autres composants ou typiquement une puce, par exemple un ASIC (acronyme de l'anglais « Application-Specific Integrated Circuit ») doté(e) de moyens de traitement de signaux issus du composant MEMS.

Le composant MEMS et/ou NEMS est réalisé à partir d'un substrat et comporte au moins un élément sensible de dimensions micrométrique ou nanométrique généralement suspendu. Pour certaines applications, le composant MEMS et/ou NEMS est protégé par un capot, de sorte à placer l'élément sensible dans une enceinte, qui peut être fermée en particulier de façon hermétique.

L'assemblage entre le composant MEMS et le boîtier est souvent sensible aux contraintes mécaniques et/ou thermiques.

De telles contraintes proviennent notamment du fait que le matériau du boîtier, par exemple un matériau plastique, une résine, ou encore un PCB (polychlorobiphényl), a généralement un coefficient de dilatation thermique très différent de celui du matériau du composant. D'autres sources de changement de contrainte peuvent avoir un effet négatif sur l'assemblage.

Pour pallier ce problème, le document EP 2 679 536 A2 propose un assemblage entre un composant MEMS protégé par un capot et un boîtier au moyen d'un cadre intermédiaire doté d'une zone d'accueil mobile et suspendue au milieu du cadre.

Un tel cadre ajouté entre le composant et le boîtier a pour inconvénient d'augmenter l'encombrement en z de l'assemblage, autrement dit dans la direction dans laquelle l'épaisseur encore appelée hauteur de l'assemblage est mesurée. Les documents DE 10 2013 211555 A1, WO 2009/060029 A1 et US 2010/300201 A1 présentent d'autres solutions au problème mentionné ci-dessus. Le document DE 10 2013 211555 A1 divulgue notamment un procédé de fabrication d'un dispositif de type MEMS avec une structure suspendue et mobile.

Il se pose le problème de réaliser un assemblage entre un composant NEMS et/ou MEMS et son boîtier associé, qui soit amélioré vis-à-vis des inconvénients indiqués ci-dessus.

### EXPOSÉ DE L'INVENTION

La présente invention prévoit un procédé de fabrication tel que définit à la revendication 1. Des modes de réalisation préférés sont définis aux revendications dépendantes.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un exemple de réalisation d'un système dans lequel un composant MEMS et/ou NEMS est assemblé sur un support de circuit intégré ou boîtier par l'intermédiaire d'une structure suspendue et mobile réalisée dans l'épaisseur même du composant ;
- la figure 2 illustre un exemple de réalisation particulier de la structure suspendue ;
- la figure 3 illustre un autre exemple de réalisation particulier de la structure suspendue ;
- la figure 4 illustre un exemple de réalisation particulier dans lequel l'assemblage entre le composant MEMS et/ou NEMS et le boîtier est en outre assuré par le biais d'une pièce rigide ;
- la figure 5 illustre un exemple de réalisation particulier dans lequel la structure suspendue et mobile est réalisée dans un capot de protection d'un élément sensible du composant MEMS et/ou NEMS ;
- la figure 6 illustre un exemple de réalisation particulier dans lequel la structure suspendue est dotée d'un ou plusieurs éléments formant butée ;
- les figures 7A-7F, 8A-8B, 9A-9B, 10A-10D servent à illustrer un exemple de procédé de fabrication d'un dispositif à composant MEMS et/ou NEMS assemblé sur un boîtier par l'intermédiaire d'une structure de découplage suspendue ;
- les figures 11A-11F, 12 servent à illustrer un autre exemple de procédé de fabrication d'un dispositif à composant MEMS et/ou NEMS assemblé sur un boîtier par l'intermédiaire d'une structure de découplage suspendue ;
- la figure 13 illustre un exemple de réalisation d'un système dans lequel un composant MEMS et/ou NEMS doté d'un premier capot de protection de son élément sensible est assemblé sur un boîtier par l'intermédiaire d'une structure suspendue et protégé par un autre capot de protection disposé sur le boîtier et formant une enceinte autour du premier capot de protection ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure comme par exemple « supérieure », « inférieure », « arrière », « avant », « sous », « sur », « latérale » s'appliquent en considérant que la structure est orientée de la façon illustrée dans les figures.

### EXPOSÉ DÉTAILLÉ DE MODES DE RÉALISATION PARTICULIERS

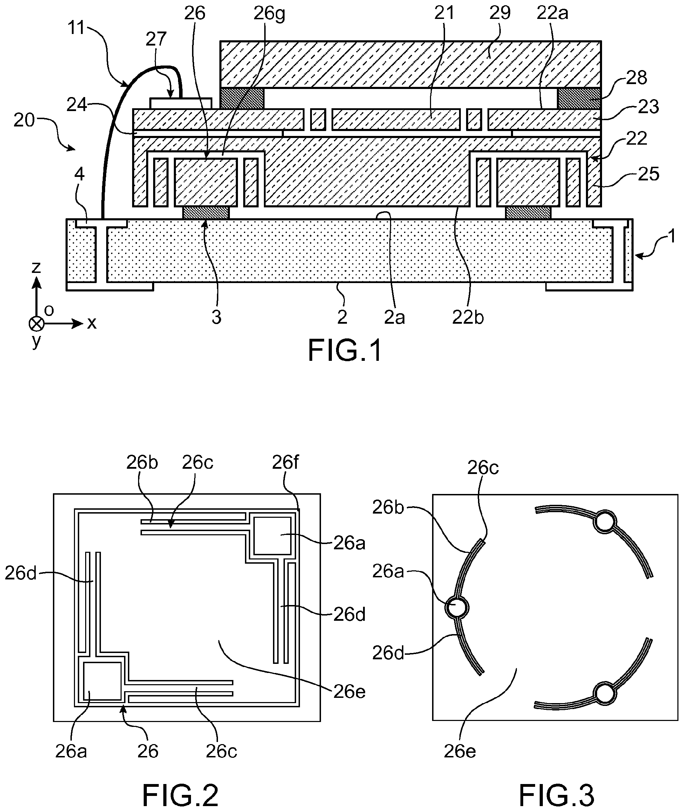

On se réfère à présent à la figure 1 illustrant un exemple de dispositif doté d'au moins une structure de découplage thermique et mécanique.

Le dispositif comprend un composant 20, dans cet exemple électromécanique de type MEMS et/ou NEMS. Le composant électromécanique 20 est doté d'au moins un élément sensible 21 typiquement suspendu, de taille micrométrique ou nanométrique. L'élément sensible 21 est réalisé à partir d'un substrat 22, c'est-à-dire dans une couche ou un empilement rapporté(e) sur ce dernier ou bien dans le matériau même de ce dernier. Par exemple, l'élément sensible 21 peut être sous forme d'une membrane ou d'une poutre, ou d'un peigne. Le composant 20 peut être prévu pour remplir une fonction de capteur, par exemple de type accéléromètre ou un gyromètre ou capteur de pression ou résonateur. Le composant 20 peut être également prévu pour remplir une fonction d'actionneur par exemple un actionneur pour dispositif optique à focale variable.

Le substrat 22 du composant 20 est dans cet exemple doté d'une couche superficielle 23 dans laquelle l'élément sensible 21 est réalisé, d'une couche intermédiaire 24 sacrificielle, qui a été gravée partiellement de sorte à permettre la libération de l'élément sensible 21, et d'une couche de support 25 dont une face forme ici une face arrière 22b du substrat 22 et du composant 20.

Le substrat 22 peut être par exemple un substrat massif (« bulk » selon la terminologie anglo-saxonne) ou un substrat de type semi-conducteur sur isolant tel qu'un substrat SOI, avec une couche superficielle 23 semi-conductrice reposant sur une couche intermédiaire 24 isolante, elle-même reposant sur une couche de support 25 semi-conductrice.

Un capot 29 de protection de l'élément sensible 21 est prévu. Ce capot 29 est disposé dans cet exemple sur la couche superficielle 23 du substrat 22 et forme une face avant 22a du composant 20, opposée à la face arrière 22b. Le capot 29 peut être par exemple en un matériau métallique, ou céramique, ou plastique, ou avantageusement semi-conducteur. Le capot 29 est agencé de telle sorte à réaliser une enceinte protectrice autour de l'élément sensible 21. Le capot 29 peut être dépourvu d'ouverture et permettre de former une enceinte fermée et hermétique dans laquelle l'élément sensible 21 est disposé. Le capot 29 peut être lié au substrat 22 par l'intermédiaire d'un cordon de scellement 28, par exemple en AlGe.

Le composant électromécanique 20 est lui-même assemblé sur un support 1, également appelé boitier 1, qui peut être par exemple formé d'un substrat 2 en matériau polymère ou céramique ou en métal. Typiquement, le support 1 est un boîtier de circuit intégré servant d'interface entre le composant électromécanique 20 et un circuit imprimé également appelé PCB pour « Printed Circuit Board » ou bien un ensemble d'autres composants.

Le support 1 comporte des régions d'accueil 3 du composant électromécanique 20, ici sous forme de plots 3 sur lesquelles des zones de fixation 26a du composant sont disposées. Les zones de fixation 26a et régions d'accueil 3 sont typiquement solidarisées par collage ou par brasure. Une colle, par exemple en matériau polymère ou un matériau de brasure est ainsi intercalé(e) entre la zone de fixation 26 et la région d'accueil 3 sur laquelle cette zone de fixation 26 est disposée.

Les zones de fixation 26a réparties en face arrière du composant 20 font partie d'une structure suspendue 26 et mobile. Cette structure suspendue 26 est notamment libre de se déplacer dans le plan, autrement dans une direction parallèle au plan principal du substrat 22, c'est-à-dire un plan passant par le substrat 22 et parallèle au plan [O ; x; y] du repère orthogonal [O; x; y; z].

La structure suspendue 26 est dans cet exemple logée au moins partiellement dans une cavité prévue dans la couche de support 25 du substrat 22. La structure suspendue 26 permet de former des parties flexibles au niveau d'un ou plusieurs des emplacements de fixation du support 1 et du composant 20.

La structure suspendue 26 permet de réaliser un moyen de découplage mécanique et thermique entre le support 1 et le composant 20. Ce moyen de découplage permet d'absorber, ou de compenser, tout ou partie des contraintes mécaniques et thermiques apparaissant par exemple lors de l'assemblage entre le support 1 et le composant 20. Ce moyen de découplage permet également de limiter l'effet de contraintes dites « thermiques », liées notamment à une différence de coefficient de dilation thermique entre le composant 20 et le boîtier ou support 1.

Une disposition de la structure de découplage 26 dans l'épaisseur du substrat 22, sans utiliser de support ou élément rapporté intermédiaire supplémentaire, permet de limiter l'encombrement en z. La structure de découplage 26 est avantageusement prévue dans une couche 25 du substrat 22 différente de la couche 23 dans laquelle l'élément sensible 21 est réalisé, ce qui permet de conserver une place suffisante pour l'élément sensible 21, et de ne pas perturber son fonctionnement.

Dans cet exemple de réalisation, la connexion électrique entre le composant électromécanique 20 et le support 1 est avantageusement dissociée des emplacements de fixation, autrement dit de la structure de découplage 26, ce qui permet de réduire le coût de réalisation des connexions. Ainsi, le matériau de brasure ou de collage entre une région d'accueil 3 et une zone de fixation 26a du composant 20 sert à lier ce dernier avec le support 1 sans véhiculer de signal électrique. Le matériau situé à l'interface entre la région d'accueil 3 et la zone de fixation 26a peut donc éventuellement être isolant. Par exemple on peut prévoir d'employer une colle polymère.

Pour assurer la connexion électrique entre le composant 20 et le support 1, on prévoit au moins un plot conducteur 27 sur le composant 20 destiné à être connecté électriquement à un plot de contact du support 1. Le plot conducteur 27 est disposé sur une face opposée à la face arrière 22b du composant 20. Dans cet exemple on prévoit au moins un plot disposé sur la couche superficielle 23.

Pour rendre plus aisée la connexion électrique entre le composant 20 et le support 1, un ou plusieurs éléments conducteurs s'étendant autour du composant 20 sans traverser son épaisseur peuvent être prévus. Typiquement, on établit une connexion à l'aide d'au moins un fil conducteur 11 qui relie le plot conducteur 27 avec une zone conductrice 4 ou plot 4 de contact du support 1. Cette zone conductrice 4 est ici située sur une face supérieure 2a du support, c'est-à-dire la face sur laquelle les plots 3 d'accueil sont agencés.

La figure 2 représente un premier exemple de réalisation de structure suspendue 26 permettant le découplage mécanique et thermique entre composant 20 et support 1.

Les zones de fixation 26a sur lesquelles des régions d'accueil du support 1 sont destinées à être assemblées sont ici disposées en périphérie de la face arrière du composant 20.

Chaque zone de fixation 26a est dans cet exemple particulier de forme rectangulaire et reliée au reste du composant 20 par l'intermédiaire de poutres 26c, 26d suspendues rattachées chacune par un point d'ancrage situé dans une portion 26e centrale elle-même rattachée au composant 20. Les poutres 26c, 26d s'étendent ici dans des directions non-parallèles l'une par rapport à l'autre. Dans cet exemple de réalisation particulier, deux poutres 26c, 26d suspendues rectilignes et orthogonales l'une par rapport à l'autre sont rattachées aux bords latéraux d'une même zone de fixation 26a. Pour permettre un déplacement des poutres 26c, 26d et de la zone 26a de fixation associée, on prévoit des tranchées 26b qui s'étendent autour des poutres 26c, 26d et de la zone de fixation 26a.

Dans ce premier exemple de réalisation, au moins une tranchée supplémentaire 26f communicant avec la ou les autres tranchées 26b est également disposée autour de la portion 26e du composant 20 à laquelle les poutres 26c, 26d sont rattachées, autorisant ainsi le déplacement dans le plan de cette portion 26e. La structure 26 de découplage peut être prévue avec un nombre de poutres et de zones de fixation différents. De même, d'autres formes de poutres 26c, 26d, et d'autres formes de zones de fixation 26a peuvent être prévues.

Un autre exemple de réalisation de structure suspendue 26 illustré sur la figure 3, prévoit plusieurs zones de fixation 26a en forme de disque, rattachées au reste du composant 20 chacune par l'intermédiaire de poutres 26c, 26d de forme courbe. Les zones de fixation 26a et poutres associées 26c, 26d sont ici réparties autour d'une portion 26e centrale de forme circulaire du composant et plus particulièrement le long de la circonférence de cette portion 26e centrale. Les tranchées 26b disposées de part et d'autre des poutres 26c et des zones de fixation ont dans cet exemple une section constante et une forme épousant celle du contour des zones de fixations 26a et de leurs poutres associées 26c, 26d.

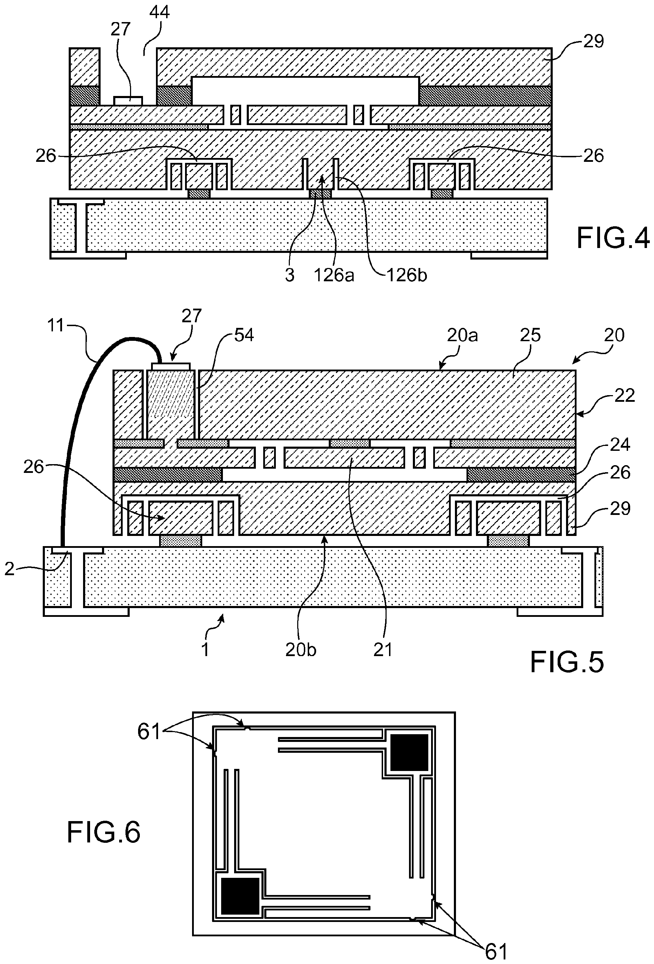

Le découplage mécanique entre le support 1 et le composant 20 peut être réalisé au niveau de tous les emplacements de fixation entre le composant 20 et le support 1 ou au niveau d'une partie seulement de ces emplacements. Ainsi, selon une variante de mise en oeuvre illustrée sur la figure 4, le composant 20 comporte une zone de fixation 126a supplémentaire, cette fois rigide, assemblée à une région d'accueil 3 du support 1. Contrairement à la structure 26 de découplage, cette zone 126a est fixe par rapport au reste du composant 20 et forme un point d'ancrage rigide pour le support 1. Cela permet d'améliorer la solidité de l'assemblage.

La zone de fixation 126a supplémentaire et la région d'accueil du support 1 sont également typiquement jointes par collage ou par brasure.

La zone de fixation 126a supplémentaire peut être prévue dans une partie centrale de la face arrière du composant 20, tandis que les zones de fixation 26a des structures suspendues sont disposées autour de cette partie centrale. Dans cet exemple particulier de réalisation, la zone de fixation 126a, est sous forme d'un plot usiné dans la couche de support 25 du substrat 22. Le plot 126a est ici entouré de rainures ou tranchées 126b. Ces rainures 126b permettent de limiter la transmission de contraintes mécaniques et thermiques au reste de la structure.

La figure 4 illustre également un autre agencement de la face avant du composant 20 qui comporte cette fois un trou 44 dévoilant un plot conducteur 27 destiné à être connecté au support 1 ou boitier 1.

Une autre manière de réduire l'encombrement en z du composant 20 tout en dotant celui-ci d'au moins une structure 26 de découplage est d'agencer cette structure 26 dans le capot 29 de protection de l'élément sensible. Ainsi, selon une autre variante de réalisation illustrée sur la figure 5, le capot 29 de protection est usiné de manière à comporter au moins une structure 26 de découplage. Le capot 29 forme cette fois la face arrière 20b du composant 20 que l'on assemble contre le support 1.

Le substrat 22 est lui aussi retourné, la face de la couche de support 25 la plus éloignée de l'élément sensible 21 formant la face avant 20a du composant 20. Le ou les plots conducteurs 27 destinés à être connectés au support 1 sont disposés en face avant 20a du composant 20, mais cette fois sur la couche de support 25 du substrat 20. Pour isoler électriquement un plot conducteur 27 du reste du substrat, on peut prévoir des tranchées 54 autour du plot conducteur 27. Ces tranchées 54 peuvent être éventuellement bouchées par un matériau isolant par exemple de type polymère ou un empilement comportant un matériau isolant par exemple un empilement de SiO₂ et de Si polycristallin.

Dans l'exemple de réalisation de la figure 5, ces tranchées 54 s'étendent jusqu'à la couche intermédiaire 24.

Dans cet exemple de réalisation tout comme dans les exemples précédents, la structure 26 de découplage est avantageusement agencée dans un niveau du composant 20 électromécanique différent de celui dans lequel se trouve l'élément sensible 21 afin de dédier davantage de place pour ce dernier.

Pour permettre d'éviter un collage intempestif de la structure de découplage 26 sur des parties du composant 20, on peut prévoir une ou plusieurs butées dans l'espace, sous forme de tranchées et/ou de cavités dans lequel la structure 26 est amenée à se déplacer. En particulier, des butées latérales anti-collage peuvent être prévues lorsque la structure 26 de découplage se déplace dans le plan.

L'exemple de réalisation illustré sur la figure 6 reprend un agencement de la structure 26 de découplage semblable à celui décrit précédemment en liaison avec la figure 2, mais avec cette fois des butées 61 sous forme de protubérances disposées sur le pourtour latéral de la portion 26e rattachée au reste du composant 20.

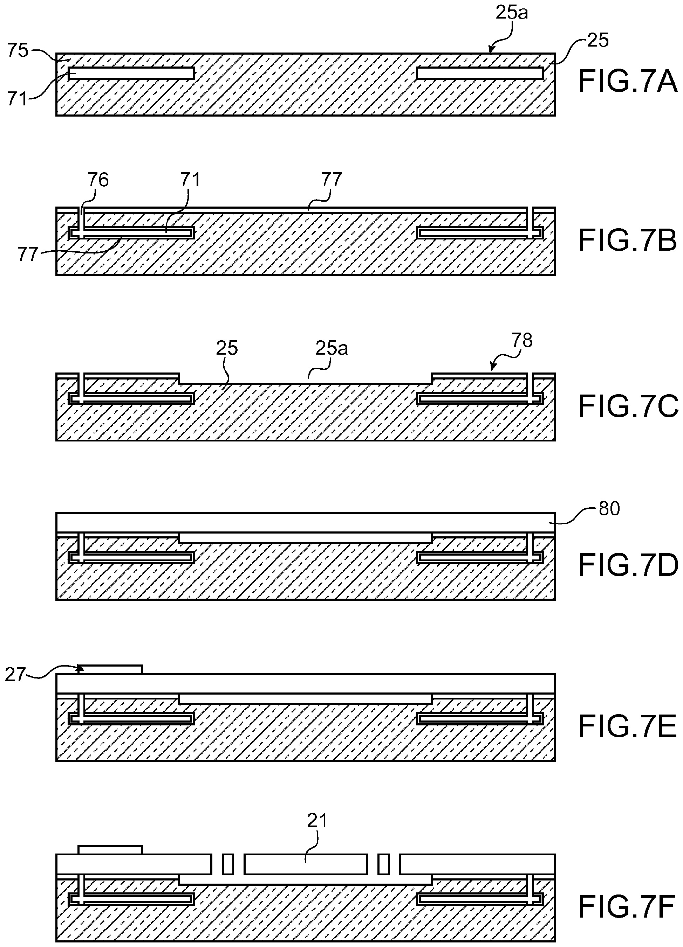

Un exemple de procédé de fabrication selon l'invention d'un composant électromécanique va à présent être décrit en liaison avec les figures 7A-7F, 8A-8B et 9A-9B.

Une structure de départ possible du procédé est illustrée sur la figure 7A sous forme d'un substrat doté d'une couche de support 25, dans laquelle on réalise des cavités enterrées 71, c'est-à-dire des cavités fermées disposées dans l'épaisseur de la couche de support 25. De telles cavités 71 sont délimitées par des membranes 75 suspendues agencées au niveau d'une face avant 25a de la couche de support 25. La couche de support 25 est typiquement un substrat massif en silicium.

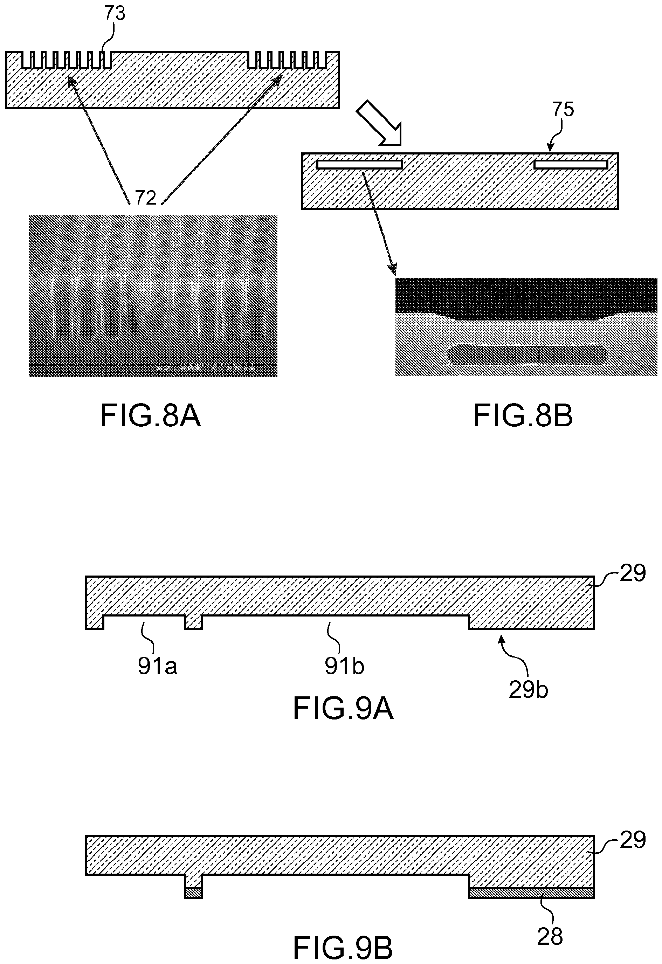

Pour réaliser de telles membranes 75, on peut employer par exemple une technique de type SON pour (« Silicon on Nothing ») dont certaines étapes sont données aux figures 8A-8B.

Sur la figure 8A, on peut voir représentées des zones 72 formées de pluralité de piliers fins 73 et disposés à faible distance les uns des autres.

Les piliers 73 présentent par exemple une largeur comprise entre environ 0,5 µm et 2 µm et sont disposés les uns des autres à une distance comprise entre environ 0,3 µm et 1 µm.

Pour réaliser ces piliers 73, lors d'une étape, on réalise par photolithographie un masque sur la surface de la couche de support 25. Au niveau où une région formée de piliers doit être réalisée, le masque définit par exemple un réseau en nid d'abeille.

Ce masque délimite les zones inter-pilier à graver. La largeur des zones inter-pilier d est par exemple comprise entre 0,3 µm et 1 µm et la distance D entre deux faces parallèles d'un pilier est par exemple comprise entre 0,5 µm et 2 µm.

Une étape de gravure de la couche de support 25 a ensuite lieu, par exemple de type DRIE avec arrêt au temps, sur une profondeur comprise typiquement entre 0,5 µm et 2 µm.

On obtient alors la structure représentée schématiquement sur la figure 8A.

Lors d'une étape suivante, le masque est retiré.

La couche ainsi formée a une épaisseur typiquement comprise entre 1 µm et quelques dizaines de µm.

Après épitaxie, on effectue un recuit haute température à une température voisine de la température de fusion dudit matériau dans le cas de piliers en Si, la température est d'environ 1200°C, ce qui fait collapser les piliers 73. Se forme alors une membrane suspendue 75 (figure 8B).

Une planarisation par polissage mécano-chimique peut être réalisée pour améliorer l'état de surface et éventuellement amincir l'épaisseur de cette membrane 75.

On peut ensuite, si nécessaire, réaliser un dépôt ou une épitaxie de matériau semi-conducteur afin d'épaissir la membrane 75.

On réalise ensuite au moins un puit d'accès 76 à la cavité enterrée 71. Cela peut être mis en oeuvre en formant un trou traversant la membrane 75 et dévoilant la cavité 76 enterrée.

On forme ensuite une couche de protection tapissant la cavité 71. Cette couche est typiquement formée par oxydation du matériau semi-conducteur de la couche de support 25. On recouvre ainsi les parois de la cavité 71 d'une couche d'oxyde 77 de silicium lorsque la couche de support est en silicium (figure 7B).

Une couche d'oxyde 77 formée en surface de la couche de support peut être quant à elle conservée comme sur la figure 7B ou bien retirée si nécessaire.

Selon une étape ultérieure illustrée sur la figure 7C, on creuse une partie de la couche de support 25 au niveau de sa face avant 25a. Cela peut être réalisé à l'aide d'étapes de photolithographie et de gravure. La gravure est effectuée de manière à conserver des parties non gravées 78 au niveau de la face avant 25a.

Ces parties 78 forment des zones d'appui sur lesquelles on rapporte ensuite un substrat ou une couche ou une plaque 80 (« wafer » selon la terminologie anglo-saxonne), typiquement semi-conductrice, par scellement ou collage direct (figure 7D). Une épaisseur de la couche 80 ou plaque 80 rapportée peut être ensuite retirée.

On forme ensuite au moins un plot conducteur 27 sur la plaque 80 ou couche 80 rapportée. Le plot 27 est typiquement réalisé par photolithographie puis gravure de matériau métallique ou d'un empilement de métaux, par exemple formé de W/WN/Au (figure 7E).

La couche ou plaque 80 est ensuite structurée pour former l'élément sensible 21. On peut réaliser pour cela des étapes de photolithographie et de gravure (figure 7F).

Sur le composant électro-mécanique ainsi réalisé, on peut ensuite rapporter un capot de protection 29 de l'élément sensible 21.

Une étape de structuration du capot 29 est illustrée sur la figure 9A.

On forme ainsi, par exemple par photolithographie et gravure, un ou plusieurs emplacements 91a, 91b dans l'épaisseur du capot 29 au niveau d'une face 29b de ce dernier. La structuration des emplacements 91a, 91b peut requérir le retrait d'une épaisseur de l'ordre de plusieurs micromètres par exemple de l'ordre de 20 µm.

Sur la figure 9B, le capot 29 est doté d'un cordon de scellement 28, par exemple formé par dépôt d'un matériau polymère. Le cordon de scellement 28 est en particulier réalisé sur des parties saillantes de la face 29b structurée du capot 29.

On effectue ensuite un assemblage entre un empilement de couches tel que réalisé précédemment et dans lequel un élément sensible 21 a été formé, et un capot 29 de protection tel que décrit précédemment, afin de compléter la fabrication du composant électromécanique.

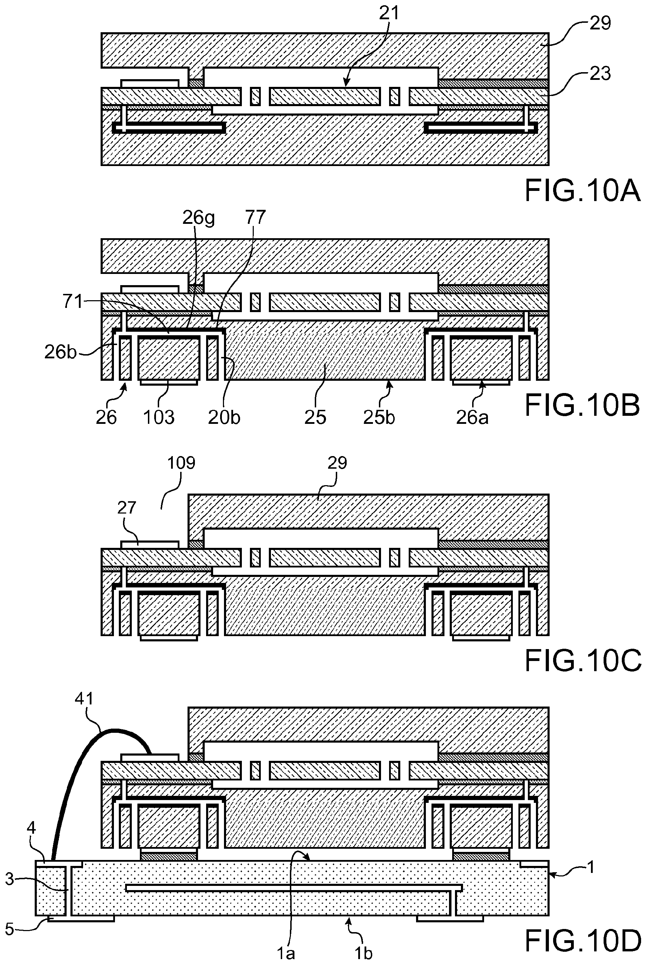

Dans l'exemple illustré sur la figure 10A, le capot 29 de protection est agencé sur la couche superficielle 23 dans laquelle l'élément sensible 21 est réalisé.

La figure 10B illustre un exemple de réalisation de la structure de découplage 26 par formation de motifs dans la couche de support 25, en particulier au niveau de sa face arrière 25b. La structuration des motifs est réalisée typiquement par photolithographie puis gravure jusqu'à dévoiler les cavités enterrées 71. La gravure est par exemple réalisée à l'aide d'un équipement de gravure silicium de type DRIE (pour « Deep Reactive Ion Etching ») lorsque la couche de support est en silicium. Avantageusement, la couche de protection 77, par exemple en oxyde de silicium, tapissant la cavité enterrée 71 sert de couche d'arrêt de gravure. La structure de découplage 26 est délimitée par des tranchées 26b communicant avec la cavité enterrée 26g.

Ensuite, sur une zone 26a du composant appelée zone de fixation, on forme un matériau 103 pour permettre un collage ou un assemblage par brasure entre cette zone de fixation 26a et une région d'accueil (non représenté sur cette figure) d'un support avec laquelle cette zone de fixation est destinée à être solidarisée. Lorsqu'on réalise un assemblage par brasure le matériau 103 peut être sous forme d'un plot en métal tel que par exemple une couche mince d'or (Au). Le matériau de brasure peut être par exemple du SnAg. On prévoit généralement une finition métallique, par exemple à base d'Au, sur le PCB au niveau de la zone de brasure.

De manière optionnelle (figure 10C), on peut ensuite réaliser au moins une ouverture 109 dans le capot 29, afin de dévoiler une partie de la couche superficielle 23, en particulier une partie sur laquelle repose au moins un plot conducteur 27 destiné à être connecté électriquement au support de circuit intégré. L'accès au plot conducteur 27 peut être réalisé par exemple par sciage du capot 29.

Une étape d'assemblage entre le composant MEMS et/ou NEMS et un support de circuit intégré est illustrée sur la figure 10D. Après l'assemblage typiquement réalisé par collage ou brasure, on établit une connexion entre au moins un plot conducteur 27 du composant 20 et un plot de contact 2 du support 1. La connexion peut être effectuée au moyen d'un procédé de micro-câblage (« wire bonding » selon la terminologie anglo-saxonne) peut être mis en oeuvre afin de réaliser un fil conducteur 11 reliant la face avant du composant électro-mécanique 20 et la face supérieure 1a du support 1 sensiblement parallèles mais situées à des niveaux différents l'une de l'autre.

Dans l'exemple d'assemblage illustré sur la figure 10D, le support 1 ou boitier 1 est doté d'un plot de contact 5 situé en face inférieure 1b du support 1 et qui est connecté au plot de contact 4 disposé en face supérieure 1a par l'intermédiaire d'une structure de connexion traversant l'épaisseur du support.

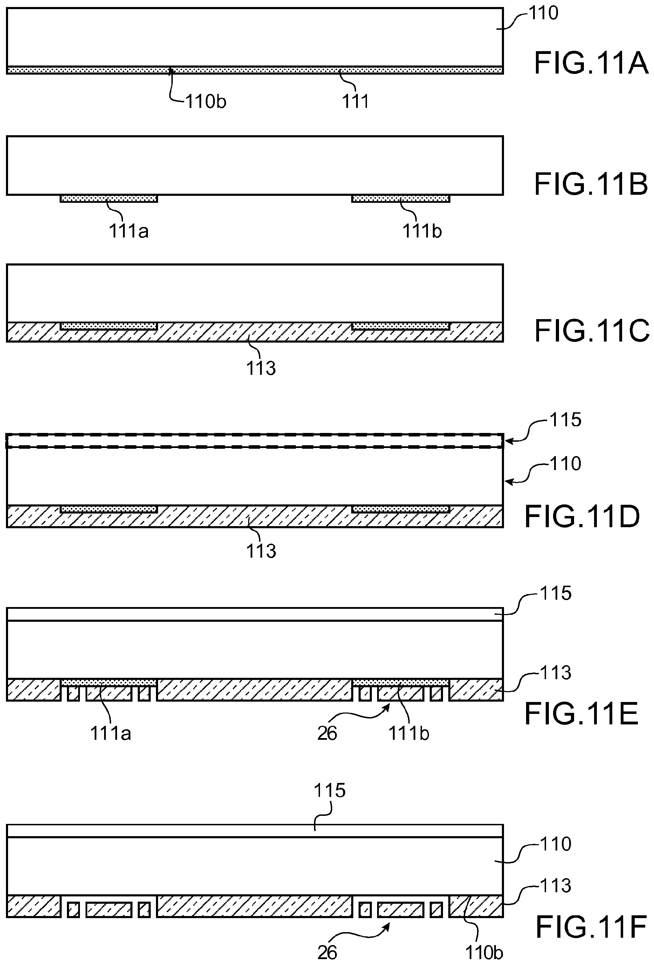

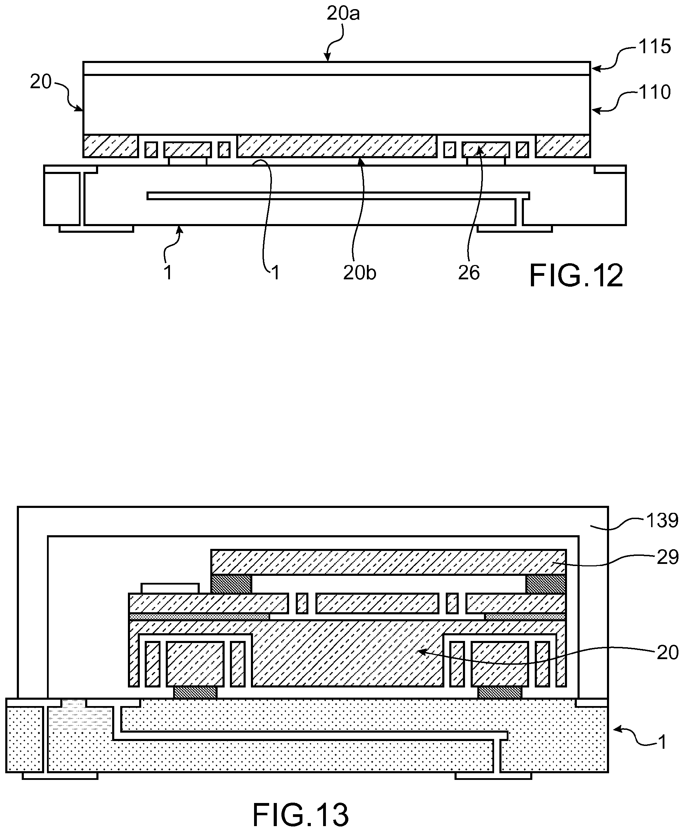

Un autre procédé de fabrication dont des étapes sont illustrées sur les figures 11A-11F et 12, prévoit la mise en oeuvre de la ou les structures de découplage 26 sur une couche 110 ou un substrat 110 sur lequel l'élément sensible 21 est également formé.

Sur une face, en particulier la face arrière 110b du substrat semi-conducteur, on forme tout d'abord une ou plusieurs zones sacrificielles.

Cela peut être effectué par exemple comme sur la figure 11A, en effectuant une oxydation thermique de sorte à former une couche 111 d'oxyde sacrificielle. La couche 111 sacrificielle peut être prévue avec une épaisseur par exemple de l'ordre du micromètre.

De manière optionnelle (figure 11B) cette couche 111 peut être ensuite structurée, par exemple par photolithographie et gravure, de manière à former des zones sacrificielles 111a, 111b distinctes.

On réalise ensuite sur la face arrière 110b du substrat 110 une couche semi-conductrice 113. Cette couche, par exemple en silicium ou en polysilicium ou en SiGe polycrystallin peut être formée par épitaxie. La couche 113 semi-conductrice peut être prévue avec une épaisseur par exemple de l'ordre d'une dizaine de micromètres. On peut ensuite effectuer une planarisation de cette couche 113 par exemple par polissage CMP.

Dans l'exemple illustré sur la figure 11D, une couche 115 (ou un empilement) de couche(s) dans laquelle (respectivement lequel) l'élément sensible du composant est réalisé, est rapportée sur la face avant 110a du substrat 110.

L'élément sensible est toutefois de préférence réalisé directement sur le substrat 110. Dans le cas où le substrat 110 est un substrat semi-conducteur sur isolant, par exemple SOI (pour « Silicon On Insulator »), la couche 115 dans laquelle est réalisée l'élément sensible correspondant à la couche mince superficielle du substrat SOI.

La figure 11E montre quant à elle une étape de structuration de la ou les structures de découplage 26 dans la couche 113 située en face arrière 110b du substrat 110. Cela peut être réalisé par photolithographie puis gravure en se servant des zones sacrificielles 111a, 111b comme zones d'arrêt de gravure.

Une étape de libération de la structure de découplage 26 par gravure des zones sacrificielles 111a, 111b est illustrée sur la figure 11F. Par exemple, pour libérer des zones sacrificielles 111a, 111b en oxyde de silicium, on peut utiliser du HF sous forme de vapeur. Pendant cette libération la couche 115 ou empilement 115 peut être protégé(e), par exemple en utilisant une couche temporaire de protection par exemple par le biais d'un couche de polymère déposée par laminage et qui pourra ensuite être retirée une fois la libération effectuée.

Un assemblage du composant 20 sur un support 1 par exemple de type PCB est ensuite illustré sur la figure 12. La face arrière 20b du composant 20 électromécanique sur laquelle se situe la structure de découplage 26 est rapportée sur la face supérieure 1a du support 1, tandis que la face avant 20a du composant 20 forme la face avant du système une fois l'assemblage réalisé.

Le système formé du boîtier 1 ou support 1 assemblé au composant 20 peut être lui-même protégé à l'aide d'un capot 139 supplémentaire agencé sur le boîtier et s'étendant autour du composant 20 et du capot 29 de ce composant. Un tel agencement est illustré par exemple sur la figure 13.

## Revendications

1. Procédé de fabrication d'un dispositif comprenant : un composant (20), en particulier de type électromécanique MEMS et/ou NEMS, ledit composant étant apte à être assemblé à un support (1), en particulier un support de circuit intégré, ledit composant (20) étant doté d'au moins un élément sensible (21) formé dans une première couche (23, 115) d'un empilement de couches (23, 24, 25, 110, 115, 113), le composant (20) électromécanique comportant au moins une structure suspendue (26) et mobile dotée d'une ou plusieurs zones (26a) de fixation sur laquelle ou lesquelles respectivement une ou plusieurs régions d'accueil (3) du support est ou sont apte(s) à être fixée(s), la structure suspendue étant formée au moins partiellement dans une deuxième couche (25) dudit empilement distincte de la première couche (23, 115),
la réalisation de ladite structure suspendue (26) comprenant des étapes de :
- formation d'au moins une cavité enterrée (71) au niveau d'une couche (25) de support,
- formation d'un puit d'accès (76) à la cavité enterrée (71),
- formation d'une couche de protection (77) tapissant la cavité enterrée (71),
- gravure de cette couche (25) de support de sorte à définir la structure suspendue (26), la gravure étant réalisée de sorte à atteindre la cavité enterrée (71) de manière à libérer la structure suspendue.

2. Procédé selon la revendication 1, dans lequel, la structure suspendue (26) est définie au niveau d'une face arrière de la couche de support (25), le procédé comprenant en outre un report d'au moins une couche superficielle au niveau d'une face avant de la couche de support (25) opposée à ladite face arrière et une structuration de la couche superficielle de sorte à former l'élément sensible (21).

3. Procédé selon l'une des revendications 1 ou 2, dans lequel la couche de support est en matériau semi-conducteur, la couche de protection (77) étant formée par oxydation du matériau semi-conducteur de la couche de support (25).

4. Procédé selon l'une des revendications 1 à 3, dans lequel la ou les structure suspendue (26) est dotée d'au moins une butée (61).

5. Procédé selon l'une des revendications 1 à 4, la couche de support étant une couche d'un substrat de type semi-conducteur sur isolant muni d'une couche superficielle (23) semi-conductrice reposant sur une couche intermédiaire (24) isolante, ladite couche intermédiaire (24) isolante reposant sur une couche de support 25 semi-conductrice.

6. Procédé selon l'une des revendications 1 à 5, dans lequel ledit composant (20) est un accéléromètre ou un gyromètre ou capteur de pression ou un résonateur.

## Patentansprüche

1. Verfahren zur Herstellung einer Vorrichtung, umfassend: Ein Bauteil (20), insbesondere in der Art eines elektromechanischen MEMS und/oder NEMS, wobei das Bauteil imstande ist, auf einem Träger (1), insbesondere einem Träger eines integrierten Schaltkreises montiert zu werden, wobei das Bauteil (20) mit mindestens einem empfindlichen Element (21) versehen ist, das in einer ersten Schicht (23, 115) einer Stapelung von Schichten (23, 24, 25, 110, 115, 113) gebildet ist, wobei das elektromechanische Bauteil (20) mindestens eine hängende und bewegliche Struktur (26) beinhaltet, die mit einer oder mehreren Befestigungszonen (26a) versehen ist, auf der oder denen jeweils eine oder mehrere Aufnahmeregionen (3) des Trägers imstande ist oder sind, befestigt zu werden, wobei die hängende Struktur mindestens teilweise in einer zweiten Schicht (25) der Stapelung gebildet ist, die sich von der ersten Schicht (23, 115) unterscheidet,
wobei die Herstellung der hängenden Struktur (26) die folgenden Schritte umfasst:
- Bilden mindestens eines verdeckten Hohlraumes (71) im Bereich einer Trägerschicht (25),
- Bilden eines Zugangsschachts (76) zum verdeckten Hohlraum (71),
- Bilden einer Schutzschicht (77), die den verdeckten Hohlraum (71) auskleidet,
- Gravieren dieser Trägerschicht (25) derart, um die hängende Struktur (26) zu definieren, wobei die Gravur derart realisiert ist, um den verdeckten Hohlraum (71) derart zu erreichen, um die hängende Struktur freizugeben.

2. Verfahren nach Anspruch 1, wobei die hängende Struktur (26) im Bereich einer Rückseite der Trägerschicht (25) definiert ist, wobei das Verfahren weiter eine Verschiebung mindestens einer Oberflächenschicht im Bereich einer Vorderseite der Trägerschicht (25) gegenüber der Rückseite, und eine Strukturierung der Oberflächenschicht derart umfasst, um das empfindliche Element (21) zu bilden.

3. Verfahren nach einem der Ansprüche 1 oder 2, wobei die Trägerschicht aus einem Halbleitermaterial ist, wobei die Schutzschicht (77) durch Oxidieren des Halbleitermaterials der Trägerschicht (25) gebildet wird.

4. Verfahren nach einem der Ansprüche 1 bis 3, wobei die hängende(n) Struktur(en) (26) mit mindestens einem Anschlag (61) versehen ist (sind).

5. Verfahren nach einem der Ansprüche 1 bis 4, wobei die Trägerschicht eine Schicht eines Substrats in der Art eines Halbleiters auf einem Isolator ist, der mit einer Halbleiter-Oberflächenschicht (23) versehen ist, die auf einer isolierenden Zwischenschicht (24) aufliegt, wobei die isolierende Zwischenschicht (24) auf einer Halbleiter-Trägerschicht 25 aufliegt.

6. Verfahren nach einem der Ansprüche 1 bis 5, wobei das Bauteil (20) ein Beschleunigungsmesser oder ein Gyrometer oder Drucksensor oder ein Resonator ist.

## Claims

1. Method for manufacturing a device comprising a component (20), in particular of MEMS and/or NEMS type the component being configured to be assembled to a support (1), in particular an integrated circuit support, the component being provided with at least one sensitive element (21) formed in a first layer (23, 115) of a stack of layers (23, 24, 25, 110, 115, 113), the electromechanical component (20) including at least one movable suspended structure (26) provided with one or more attachment zones (26a) on which one or more accommodating regions (3) for accommodating the support is able to be attached, the suspended structure being formed at least partially in a second layer (25) of said stack, distinct from the first layer (23, 115), the method comprising:
forming the suspended structure (26) comprising steps of:
forming at least one buried cavity (71) in a support layer (25),
forming an access pit (76) to the buried cavity (71),
forming a protective layer (77) coating the buried cavity (71), and
etching the support layer (25) so as to define the suspended structure (26), wherein the etching reaches the buried cavity (71) so as to release the suspended structure.

2. Method according to claim 1, wherein the suspended structure (26) is defined at a rear face of the support layer (25), the method further comprising transferring at least one superficial layer at a front face of the support layer (25) opposite to said rear face and structuring the superficial layer so as to form the sensitive element (21).

3. Method according to claim 1 or 2, wherein the support layer is made of a semiconductor material, the protective layer (77) being formed by oxidizing the semiconductor material of the support layer (25).

4. Method according to any of the claims 1 to 3, comprising forming the suspended structure (26) to have at least one stop (61).

5. Method according to any of the claims 1 to 4, the support layer being a layer of a semiconductor on insulator type substrate provided with a semiconducting superficial layer (23) lying on an insulating intermediate layer (24), said insulating intermediate layer lying on a semiconducting support layer (25).

6. The method according to any of the claims 1 to 5, wherein said component (20) is one of an accelerometer, gyrometer, pressure sensor and resonator.
